Europäisches Patentamt

European Patent Office

Office européen des brevets

(11) Veröffentlichungsnummer: **0 154 661**
**A1**

## (12) EUROPÄISCHE PATENTANMELDUNG

(21) Anmeldenummer: 84102876.4

(22) Anmeldetag: 15.03.84

(51) Int. Cl.⁴: **H 03 M 1/64**

(43) Veröffentlichungstag der Anmeldung: **18.09.85**
**Patentblatt 85/38**

(71) Anmelder: **Werba, Hans, Theresienstrasse 11,**
**D-8390 Passau (DE)**

(72) Erfinder: **Werba, Hans, Theresienstrasse 11,**
**D-8390 Passau (DE)**

(84) Benannte Vertragsstaaten: **FR GB IT**

(74) Vertreter: **Kador . Klunker . Schmitt-Nilson . Hirsch,**
**Corneliusstrasse 15, D-8000 München 5 (DE)**

(54) Analog/Digital-Wandler.

(57) Bei einem Analog/Digital-Wandler, der ein Paar mit einem Hilfssignal gespeiste Laufzeitleitungen aufweist, denen eine vom umzusetzenden Analogsignal steuerbare Phasenveränderungseinrichtung zugeordnet ist, sind längs der beiden Laufzeitleitungen je mehrere Abgriffe vorgesehen, wobei je zwei zueinander gehörige Abgriffe beider Leitungen ein Meßpaar bilden. Bis auf ein Meßpaar ist der Abstand der beiden Abgriffspunkte eines jeden Meßpaares vom Anfang der Laufzeitleitungen unterschiedlich. Außerdem ist der Unterschied zwischen den Abständen der Abgriffspunkte eines Meßpaares von den Leitungsanfängen für die verschiedenen Meßpaare unterschiedlich. Jedem Meßpaar ist eine Vergleichsvorrichtung zugeordnet, mittels welcher an dem zugehörigen Meßpaar die auf die Laufzeitleitungen gegebenen Hilfssignale auf Koinzidenz oder Auslöschung verglichen werden. Das Ausgangssignalmuster aller Vergleichseinrichtungen bildet das dem umzusetzenden Analogsignal entsprechende Quantisierungsmuster.

A/D Wandler

Analog/Digital-Wandler

---

Die Erfindung betrifft einen Analog/Digital-Wandler mit einem Paar Laufzeitleitungen, die eingangsseitig mit Hilfssignalen gleicher Signalform beaufschlagt werden, wobei diese Signale durch Impulse gebildet werden, mit einer steuerbaren Phasenveränderungseinrichtung, mittels der unter Steuerung durch das umzusetzende Analogsignal ein Phasenunterschied zwischen den Hilfssignalen auf den beiden Laufzeitleitungen entsprechend der Analogsignaländerung modulierbar ist, und mit einer Vergleichsvorrichtung, mittels welcher an vorbestimmten Abgriffspunkten an den beiden Laufzeitleitungen die Hilfssignale auf den beiden Laufzeitleitungen auf Betragsgleichheit oder Betragsungleichheit verglichen werden.

Herkömmliche Analog/Digital-Wandler eignen sich nur zur Umsetzung von analogen Wechselsignalen bis in den unteren MHz-Bereich. Die Analog/Digital-Umsetzung von Analogssignalen mit höheren Frequenzen ist beispielsweise bei der oszillographischen Darstellung von Analogsignalvorgängen, zur digitalen Verarbeitung von Fernsehsignalen im UHF-Bereich und bei der Signalverarbeitung im Mikrowellenbereich erwünscht.

Von einem Analog/Digital-Wandler der eingangs angegebenen Art wird berichtet in der Zeitschrift "Elektronik" vom 24.09.1982, Seite 28. Dieser Analog/Digital-Wandler (im folgenden abgekürzt mit A/D-Wandler) ist für Analogsignale bis 1 GHz verwendbar. Er arbeitet mit Lichtleitungen, die von einem gepulsten Lasersignal gespeist werden. Die Lichtleiterbahnen verzweigen sich und pro Bit Auflösung ist ein Ausgangskanal mit zwei parallelen Lichtleiterbahnen vorgesehen, die eine Interferometerstufe aufweisen. In einer Lichtleiterbahn eines jeden Kanals ist die Geschwindigkeit des Lichtsignals in Abhängigkeit von dem Analogsignal veränderbar, während die andere Lichtleiterbahn des Kanal unbeeinflußt bleibt. Werden die beiden Lichtleiterbahnen eines Kanals wieder zusammengeführt, erhält man ein mehr oder weniger gedämpftes Signal entsprechend der Phasendifferenz zwischen den beiden Zweigen des Signals. Möchte man beispielsweise eine Auflösung von 4 Bit haben, benötigt man vier solche Kanäle mit je zwei Lichtleiterbahnen und einer Interferometerstufe. Mit einem Lichtleiterpaar alleine läßt sich für das umzuwandelnde Analogsignal nur eine einzige Quantisierungsaussage machen, nämlich ob das Analogsignal unterhalb oder oberhalb einer Quantisierungsstufe liegt.

Der Erfindung liegt die Aufgabe zugrunde, einen Analog/Digital-Wandler der eingangs angegebenen Art verfügbar zu machen, der rein elektrisch betrieben werden kann und bei dem mit verringertem Aufwand eine höhere Quantisierungsauflösung erzielt werden kann.

Diese Aufgabe wird mit einem Analog/Digital-Wandler der eingangs angegebenen Art gelöst, der dadurch gekennzeichnet ist, daß jede Laufzeitleitung mehrere in Längsrichtung versetzte Abgriffe aufweist, daß der erste, der zweite, der dritte u.s.w. Abgriff einer Laufzeitleitung mit dem ersten bzw. zweiten bzw. dritten u.s.w. Abgriff der anderen Laufzeitleitung je ein Meßpaar bilden,

- 3 -

0154661

daß der Abstand der beiden Abgriffspunkte eines jeden
Meßpaares, mit Ausnahme eines Meßpaares, vom Anfang
der Laufzeitleitungen unterschiedlich ist, daß der Unterschied zwischen den Abständen der Abgriffspunkte eines
Meßpaares von den Leitungsanfängen für die verschiedenen
Meßpaares ebenfalls unterschiedlich ist, daß jedem Meßpaar eine Vergleichsvorrichtung zugeordenet ist und daß
die Vergleichsergebnisse aller Vergleichsvorrichtungen
das dem umzusetzenden Analogsignal entsprechende Quantisierungsmuster bilden.

Der erfindungsgemäße A/D-Wandler arbeitet nach folgendem
Prinzip:

Gibt man auf den Eingang einer Laufzeitleitung mit
mehreren Abgriffen längs dieser Leitung einen Impuls,
kann dieser Impuls während seines Laufes durch die Laufzeitleitung an den aufeinanderfolgenden Abgriffspunkten
nacheinander festgestellt werden. Speist man nun diesen
Impuls gleichzeitig in zwei Laufzeitleitungen ein, die
erfindungsgemäß verteilte Abgriffe aufweisen, kann dieser
Impuls an demjenigen Meßpaar, dessen Abgriffspunkte einen
gleichen Abstand von den Anfängen der beiden Laufzeitleitungen haben, gleichzeitig festgestellt werden. Bei
jedem anderen Meßpaar wird der Impuls an den zugehörigen
Abgriffspunkten zu verschiedener Zeit festgestellt, weil
die beiden Abgriffspunkte jedes dieser anderen Meßpaare
einen unterschiedlichen Abstand von den Leitungsanfängen
der beiden Laufzeitleitungen aufweisen. Speist man nun
den Impuls zu verschiedenen Zeiten in die beiden Laufzeitleitungen ein, wird der Impuls

nicht mehr gleichzeitig an dem Meßpaar festgestellt,
dessen Abgriffspunkte gleichweit von den Leitungsanfängen entfernt sind, sondern von irgendeinem der
anderen Meßpaare. An welchem dieser anderen Meßpaare
der Impuls gleichzeitig festgestellt wird, hängt davon
ab, wie stark die Einspeisung des Impulses in die eine
Laufzeitleitung gegenüber der Einspeisung des Impulses
in die andere Laufzeitleitung verzögert ist. Diese zueinander verzögerte Einspeisung des Impulses in die Laufzeitleitungen wird mittels der steuerbaren Phasenveränderungseinrichtung bewirkt. Die von dieser Phasenveränderungseinrichtung bewirkte Phasenänderung wird mit
dem umzusetzenden Analogsignal gesteuert, somit wird
das gleichzeitige Auftreten des in die beiden Laufzeitleitungen eingespeisten Impulses jeweils an einem der
Meßpaare festgestellt, das von dem Momentanwert des
Analogsignals abhängt. Ändert sich der Momentwert des
Analogsignals, ändert sich auch das Meßpaar, an dem das
gleichzeitige Auftreten des Impulses festgestellt wird.
Ob an einem bestimmten Meßpaar der Impuls gleichzeitig auftritt, wird mit Hilfe der Vergleichseinrichtung ermittelt.
Diese Vergleichseinrichtung zeigt an ihrem Ausgang an, ob
an dem ihr zugeordneten Meßpaar der auf die beiden Laufzeitleitungen gegebene Impuls gleichzeitig auftritt oder
nicht. Beispielsweise kann das gleichzeitige Auftreten
des Impulses an einem Meßpaar durch den Logikwert "1"
und das nicht-gleichzeitige Auftreten des Impulses an
den beiden Abgriffspunkten eines Meßpaares durch den
Logikwert "0" ausgedrückt werden.

Somit entspricht die Logikwertverteilung an den Ausgängen der Vergleichseinrichtungen dem Momentanwert des umzusetzenden Analogsignals. Eine Änderung des Momentanwerts des Analogsignals führt zu einer Änderung dieses Logikwertmusters. Das Logikwertmuster bildet daher das Quantisierungsmuster für den umzusetzenden Analogsignalwert.

Bei dem erfindungsgemäßen A/D-Wandler kann vorteilhafterweise mit nur zwei Laufzeitleitungen eine praktisch beliebig hohe Quantisierungsauflösung des umzusetzenden Analogsignalwertes erreichen. Je größer die Anzahl der längs der Laufzeitleitungen verteilten Meßpaare ist, um so höher ist die Quantisierungsauflösung, d.h. um so kleiner sind die Quantisierungsstufen und damit die Umsetzfehler und das Quantisierungsrauschen.

Als Hilfssignal können beispielsweise Rechteckimpulse, Nadelimpulse, Dreieckimpulse, Sinushalbwellen verwendet werden, vorzugsweise in Form einer periodischen Impulsfolge. Als Hilfssignal kann man allerdings auch ein Dauersinussignal oder ein ähnliches Dauerschwingungssignal verwenden. In diesem Fall wird man vorteilhafterweise mit den Meßpaaren solche Stellen auf den Laufzeitleitungen aufsuchen, an denen sich die Dauersignalschwingung auf den beiden Laufzeitleitungen bei Überlagerung auslöscht. D.h., mit den einzelnen Meßpaaren werden diejenigen Stellen der Laufzeitleitungen aufgesucht, an denen die Dauersignalschwingung auf den beiden Laufzeitleitungen einen Phasenunterschied von 180° aufweist. Die Vergleichseinrichtungen führen bei dieser Ausführungsform der Erfindung vorteilhafterweise eine Summierung der an den Abgriffpunkten des zugehörigen Meßpaares auftretenden Signalwerte durch und zeigen an ihrem
Ausgang, ob sich die Signalwerte an den beiden Abgriffspunkten aufheben bzw. auslöschen (beispielsweise Logikwert "0") oder nicht aufheben bzw. auslöschen (beispielsweise Logikwert "1"). Der Auslöschungspunkt verschiebt
sich wieder in Abhängigkeit von dem jeweiligen Momentanwert des Analogsignals, so daß man auch in diesem Fall
wieder an den Ausgängen der Vergleichseinrichtungen das
Quantisierungsmuster des jeweils umzusetzenden Analogsignalwertes erhält.

Die Laufzeitleitungen können beispielsweise als Koaxialkabel, Streifenleitungen, Hohlleiter oder auch Kettenleiter beispielsweise mit LC-Gliedern aufgebaut sein.

Eine weitere Möglichkeit einer erfindungsgemäß   verwendbaren
Laufzeitleitung ist die Hintereinanderschaltung einer Mehrzahl
von Gattern, die je ein Verzögerungsglied bilden. Dabei kann
die unterschiedliche Laufzeit in den beiden Laufzeitleitungen
durch eine unterschiedliche Anzahl von Gattern in den beiden
Laufzeitleitungen oder durch die Verwendung unterschiedlich
stark verzögernder Gatter in den beiden Laufzeitleitungen
erzielt werden.

Das erfindungsgemäße Prinzip läßt sich mit einem Phasenschieber, der vor den Leitungsanfang einer der beiden
Laufzeitleitungen geschaltet ist, verwirklichen. Vorzugsweise werden aber zwei Phasenschieber verwendet,
die je vor den Leitungsanfang einer der beiden Laufzeitleitungen geschaltet sind. Um Analogsignale sowohl
mit positiver als auch mit negativer Polarität umsetzen
zu können, wird der bzw. jeder Phasenschieber in Ruhestellung vorzugsweise so ausgelegt, daß er bei einem
Analogsignal 0 eine Phasenverschiebung von 90° bewirkt.
Je nach dem, ob der momentane Analogsignalwert positive
oder negative Polarität aufweist, kann dann die Phasenverschiebung in Richtung zu 180° oder in Richtung auf
0° verändert werden. Für den Fall, daß vor jede Laufzeitleitung ein Phasenschieber geschaltet ist, wird
die Phasenverschiebung des einen Phasenschiebers vom
Analogsignal gegensinnig zur Phasenverschiebung des
andern Phasenschiebers gesteuert.

Das an den Ausgängen der Vergleichseinrichtungen auftretende Quantisierungsmuster kann je nach Bedarf benutzt oder weiter verarbeitet werden. Vorzugsweise sind
die Ausgänge der einzelnen Vergleichseinrichtungen an
die einzelnen Stufen einer Speichereinrichtung angeschlossen, in welche die Quantisierungsmuster an den
Ausgängen der Vergleichseinrichtungen unter Verwendung
von Einlesetaktsignalen eingelesen werden können. Bei
einer besonders bevorzugten Ausführungsform ist an den
Ausgang einer jeden Vergleichseinrichtung die Eingangsstufe eines mehrstufigen Schieberegisters angeschlossen.
Mit Hilfe einer dritten Laufzeitleitung, in die ebenfalls
die Impulse bzw. das Dauerschwingungssignal der Hilfssignalquelle eingespeist wird, werden für die einzelnen
Schieberegister individuelle Verschiebetaktsignale erzeugt. Zu diesem Zweck weist die dritte Laufzeitleitung
ebenfalls eine Reihe von Abgriffen auf, die je zusammen
mit einem Meßpaar der ersten beiden Laufzeitleitungen
ein Meßtripel bilden. Dabei ist bei jedem Meßtripel der
Abstand des Abgriffpunktes an der dritten Laufzeitleitung
vom Anfang dieser dritten Laufzeitleitung gleich dem
arithmetischen Mittel der Abstände der Abgriffspunkte
des zugehörigen Meßpaares der beiden anderen Laufzeitleitungen. Damit wird erreicht, daß das
einer bestimmten Vergleichseinrichtung zugeordnete Schieberegister immer zu solchen Zeitpunkten
einspeicherbereit gemacht wird, zu welchen an der zugehörigen Vergleichseinrichtung Übereinstimmung bzw.
Auslöschung des Hilfssignals auf den anderen beiden
Laufzeitleitungen festgestellt würde, wenn der jeweils
umzusetzende Analogsignalmomentanwert ein gleichzeitiges
Auftreten bzw. Auslöschung des Hilfssignals an diesem
Meßpaar bewirken würde. Damit wird erreicht, daß ein neues Hilfssignal schon auf die Laufzeitleitungen gegeben werden kann, bevor das vorausgehende Hilfssignal
die Laufzeitleitungen vollständig durchlaufen hat. Jeder
neu eingespeiste Hilfssignal-Impuls öffnet sozusagen
selbsttätig die einzelnen Schieberegister zu dem Zeitpunkt, zu dem dieser Impuls an dem zu diesem Schieberegister gehörenden Meßpaar vorbeiläuft, so daß jedes
Schieberegister beim Vorbeilaufen des Impulses am entsprechenden Meßpaar sofort das Ergebnis des Vergleichs ,
ob das Hilfssignal an diesem Meßpaar gleichzeitig ankommt bzw. eine Auslöschung erfährt oder nicht, übernehmen kann. Zweckmäßigerweise wird das in den letzten
Stufen der Schieberegister gespeicherte Quantisierungsmuster in ein Pufferregister übergeben, von wo aus es
dann mit einem Auslesetakt abgefragt werden kann.

Damit die von den Abgriffen der dritten Laufzeitleitung
abgenommenen Verschiebeimpulse für die Schieberegister
ausreichend breit sind, wird das auf die dritte Laufzeitleitung geschickte Hilfssignal mittels zweier Verzögerungsglieder verzögert und einmal unverzögert, einmal durch
eine der Verzögerungsglieder verzögert und zum dritten
durch beide Verzögerungsglieder verzögert auf die dritte
Laufzeitleitung gegeben. Durch die dritte Laufzeitleitung
läuft dann ein verbreitertes Hilfssignal.

Bisher wurde die Möglichkeit beschrieben, an zwei Laufzeitleitungen die Abgriffe eines jeden Meßpaares, mit Ausnahme
eines Meßpaares, in unterschiedlichem Abstand vom jeweiligen
Leitungsanfang anzuordnen, um verschiedene Laufzeiten von den
Leitungsanfängen bis zu den beiden Abgriffen der einzelnen
Meßpaare zu erreichen. Solche unterschiedlichen Laufzeiten
von den Leitungsanfängen bis zu den Abgriffen der einzelnen
Meßpaare kann man jedoch auch dadurch erreichen, daß man
die beiden Laufzeitleitungen für unterschiedliche Gruppengeschwindigkeiten auslegt. Dann kann man die Abgriffe der einzelnen Meßpaare in gleichem geometrischen Abstand von den
Leitungsanfängen anordnen. In diesem Fall sind nur die elektrisch
wirksamen Längen verschieden, die geometrischen Längen jedoch
gleich.

Auch eine Mischung dieser beiden Maßnahmen zur Erzielung unterschiedlicher Laufzeiten bis zu den Abgriffen der einzelnen
Meßpaare ist möglich, nämlich die Auslegung der beiden Laufzeitleitungen für unterschiedliche Gruppenlaufzeiten und die
Anordnung der Abgriffe der einzelnen Meßpaare in unterschiedlichen geometrischen Abständen von den Leitungsanfängen.

Der erfindungsgemäße Analaog/Digitalwandler läßt sich in
vorteilhafter Weise als Stufenschalter einsetzen, der mehrere
Schalterausgänge aufweist, an denen der Reihe nach in zeitlicher Versetzung Schaltsteuersignale auftreten. Zu diesem
Zweck legt man an die steuerbare Phasenveränderungseinrichtung als Analogsignal ein Sägezahnsignal an. Der Ort  längs
der Laufzeitleitungsanordnung, an dem Koinzidenz der beiden
Hilfssignale auftritt, ändert sich mit dem Sägezahnverlauf.
Der Logikwert, der an derjenigen Vergleichsvorrichtung
erscheint, bei welcher jeweils die Koinzidenz auftritt,
wandert dann der Reihe nach mit zeitlicher Versetzung von
Vergleichsvorrichtung zu Vergleichsvorrichtung. Dieser Logikwert kann, gegebenenfalls nach einer Inversion, "0" oder "1" sein. Die einzelnen Vergleichsvorrichtungen bilden dabei die einzelnen Ausgänge des Stufenschalters. Betrachtet man beispielsweise einen Stufenschalter mit vier Ausgängen, denen je eine Vergleichsvorrichtung zugeordnet ist, so tritt das Schaltsteuersignal, beispielsweise der Logikwert "1", jeweils immer nur an einem Schalterausgang auf, nämlich am ersten Schalterausgang zum Zeitpunkt t1, am zweiten Schalterausgang zum Zeitpunkt t2, am dritten Schalterausgang zum Zeitpunkt t3 und am vierten Schalterausgang zum Zeitpunkt t4. Nimmt man zum Beispiel gleiche Abstände der den Vergleichsvorrichtungen zugeordneten Abgriffen voneinander an, tritt der den Ort der Koinzidenz kennzeichnende Logikwert an benachbarten Vergleichsvorrichtungen mit gleichen Zeitabständen $\Delta t$ auf.

Durch Verändern des Anstieges des Sägezahnsignals kann man nun die Zeitlagen der Zeitpunkte t1 bis t4 und die zeitlichen Abstände $\Delta t$ zwischen ihnen variieren.

Ein solcher Stufenschalter läßt sich zum Beispiel zur variablen Steuerung von Multiplexsystemen verwenden. Lediglich durch Verändern der Steigung des analogen Sägezahnsignals lassen sich die Zeitlagen und Zeitlagenabstände des Multiplexsystems variieren.

Weitere vorteilhafte Weiterbildungen der Erfindung sind in weiteren Unteransprüchen angegeben.

Die Erfindung und Weiterbildungen der Erfindung werden nun anhand von Ausführungsformen näher erläutert. In den Zeichnungen zeigen:

Fig. 1 eine erste Ausführungsform eines erfindungsgemäßen A/D-Wandlers; und

Fig. 2 eine zweite Ausführungsform eines erfindungsgemäßen A/D-Wandlers.

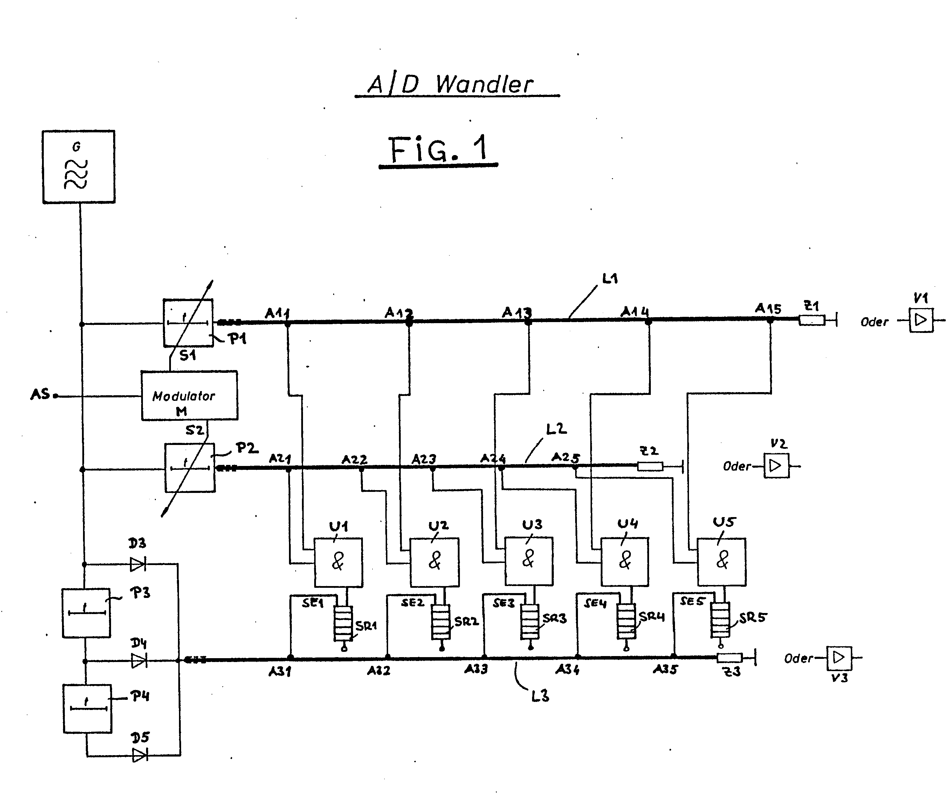

In Fig. 1 sind zwei Laufzeitleitungen L1 und L2 vorgesehen, die je mit mehreren Abgriffen A11, A12 ... bzw.
A21, A22, ... versehen sind. Die Abstände zwischen den
Abgriffen A11, A12, ... der Laufzeitleitung L1, im folgenden lange Laufzeitleitung genannt, sind größer als die
Abstände zwischen den Abgriffen A21, A22, ... der Laufzeitleitung L2, im folgende kurze Laufzeitleitung genannt. Die beiden ersten Abgriffe A11 und A21 bilden
ein erstes Meßpaar, die beiden zweiten Abgriffe A12 und
A22 bilden ein zweites Meßpaar, u.s.w.  In Fig. 1 sind
fünf Meßpaare dargestellt. In Wirklichkeit kann die Anzahl der Meßpaare aber erheblich höher sein.

Die beiden Abgriffe A11 und A21 des ersten Meßpaares
haben von den Anfängen der beiden Laufzeitleitungen
L1 und L2 einen gleichen Abstand. Die Abgriffspunkte
der weiteren Meßpaare haben von den Anfängen der beiden
Laufzeitleitungen L1 und L2 alle verschiedene Abstände.
Außerdem ist der Unterschied zwischen den Abständen der
Abgriffspunkte eines Meßpaares von den Anfängen der Laufzeitleitungen L1 und L2 für die verschiedenen Meßpaare
ebenfalls unterschiedlich. Beispielsweise ist der Unterschied zwischen den Abständen der Abgriffspunkte A12 und
A22 vom Anfang der jeweiligen Laufzeitleitung L1 bzw. L2
geringer als der Unterschied zwischen den Abständen der
Abgriffspunkte A15 und A25 vom Anfang der jeweiligen
Laufzeitleitung L1 bzw. L2. Die Abgriffe eines jeden Meßpaares sind mit den Eingängen eines als Vergleichseinrichtung dienenden UND-Gliedes U1, U2, ... verbunden.
Am Ausgang eines jeden UND-Gliedes wird mit den Logikwerten "1" und "0" angezeigt, ob an den zugehörigen Abgriffspunkten das gleichzeitige Vorhandensein eines Impulses festgestellt wird oder nicht.

Solche Impulse stammen von einer Hilfssignalquelle, die
den beiden Laufzeitleitungen L1 und L2 über je einen
steuerbaren Phasenschieber P1 bzw. P2 zugeführt werden.
Der Steuereingang S1 bzw. S2 jedes dieser Phasenschieber
P1 und P2 ist mit dem Ausgangs eines Modulators M verbunden, dessen Eingang das in Digitalform umzuwandelnde
Analogsignal zugeführt wird. Beim Nichtanliegen eines
Analogsignals bzw. beim Anliegen des Analogsignalwertes
0 sind beide steuerbaren Phasenschieber P1 und P2 auf
eine Phasenverschiebung von 90° eingestellt. In diesem
Fall gelangt ein vom Hilfssignalgenerator G gelieferter
Impuls zur gleichen Zeit auf den Leitungsanfang einer
jeden der beiden Laufzeitleitungen L1 und L2. Der Impuls auf jeder dieser Laufzeitleitungen L1 und L2
passiert die Abgriffspunkte A11 und A21 des ersten
Meßpaares gleichzeitig, und zu diesem Zeitpunkt zeigt
der Ausgang der ersten UND-Schaltung U1 das gleichzeitige Anliegen des Impulses an den Abgriffspunkten
dieses Meßpaares an. Wenn der Impuls dann auf beiden
Laufzeitleitungen L1  und L2 weiterläuft, passiert er
den Abgriffspunkt A22 der kurzen Laufzeitleitung L2
früher als den zugehörigen Abgriffspunkt A12 der langen
Laufzeitleitung L1. In verstärktem Maße gilt dies für
die Abgriffspunkte der nachfolgenden Meßpaare. Wenn man
nun beispielsweise an die Ausgänge der einzelnen UND-
Glieder U1, U2 ... Speicherschaltungen anschließt, beispielsweise in Form von Abtast- und Halteschaltungen
oder in Form von Schieberegistern, kann man in diesen
Speichern bzw. Schieberegistern die Zustände an den
Ausgängen der UND-Schaltungen U1, U2, ..., zu den Zeitpunkten, zu denen der Impuls auf den beiden Leitungen
die zugehörigen Meßpaare passiert, als Quantisierungsmuster festhalten. Für einen Analogsignalwert 0 weist
beispielsweise nur der Speicher am Ausgang des ersten
UND-Gliedes U1 den Logikwert "1" (oder "0") auf, während
die Ausgänge aller anderen UND-Glieder U2, U3 ... den
Logikwert "0" (bzw. "1") aufweisen.

Bei einem von 0 verschiedenen momentanen Analogsignalwert wird eine bestimmte Phasenverschiebung zwischen
den vom Hilfsgenerator G gelieferten Impulsen für beide
Laufzeitleitungen L1 und L2 eingestellt. Dadurch ergibt sich
an irgendeinem anderen Meßpaar  das gleichzeitige Auftreten der durch die beiden Laufzeitleitungen L1 und L2
laufenden Impulse, so daß an dem Ausgang eines anderen
UND-Gliedes das gleichzeitige Auftreten dieser beiden
Impulse festgestellt wird. Dadurch ergibt sich an den
Ausgängen der UND-Glieder bzw. in den an die UND-Glieder
angeschlossenen Speichern eine andere Verteilung der Logikwerte "1" und "0", nämlich entsprechend dem jeweils umgesetzten Momentanwert des Analogsignals. D.h.,das Logikwertmuster an allen Vergleichseinrichtungen bzw. der UND-
Glieder U1, U2 ... stellt eine Kodierung des umzusetzenden
Analogsignalwertes in digitaler Form dar.

Sind die beiden Phasenschieber P1 und P2 beim Analogsignalwert 0 je auf 90° Phasenverschiebung eingestellt,
wird bei einem negativen Signalwert des Analogsignals beispielsweise der Phasenschieber der langen Laufzeitleitung L1 von 90° in Richtung 0° geschoben und der
Phasenschieber P2 der kurzen Laufzeitleitung von 90°
in Richtung zu 180° geschoben.

Die Laufzeitleitungen L1 und L2 werden so abgeschlossen,
daß keine Reflexion zurück zum Leitungsanfang auftritt,
die den Meßvergleich stören könnte. D.h., die Laufzeitleitungen L1 und L2 werden mit Impedanzelementen Z1 und Z2
abgeschlossen, deren Impedanzwert gleich dem Wellenwiderstand der Laufzeitleitung ist.

Bei einer sehr großen Anzahl von Abgriffspaaren kann es
vorteilhaft sein, in die Laufzeitleitungen Zwischenverstärker einzuschalten, wie sie in Fig. 1 mit den mit
V1 und V1 bezeichneten Verstärkersymbolen angedeutet
sind.

Anstelle der UND-Glieder U1, U2, ... können auch NAND-
Glieder, Komparatoren oder ähnliche Schaltungen verwendet werden.

Bei der in Fig. 1 dargestellten Ausführungsform werden
die Zustände an den Ausgängen der UND-Glieder U1, U2,...
bevorzugtermaßen je in die erste Stufe eines Schieberegisters SR1, SR2, ... eingespeichert. Dabei werden
den Verschiebetakteingängen SE1, SE2, ... der Schieberegister SR1, SR2, ... Verschiebetakte zugeführt, die
von den Abgriffen A31, A32, A33, ... einer dritten
Laufzeitleitung L3 abgeleitet werden. Auch in die
dritte Laufzeitleitung L3 werden die Impulse von der Hilfssignalquelle G eingespeist. Zur Verbreiterung der von den Abgriffen A31, A32, ... abgenommenen Verschiebetaktimpulse dient ein Netzwerk aus drei gleichsinnig gepolten, parallel geschalteten Dioden D3, D4 und D5, deren Kathoden gemeinsam mit dem Eingang der dritten Laufzeitleitung 3 verbunden sind. Die Anode der obersten Diode D3 ist direkt mit dem Ausgang der Hilfssignalquelle G verbunden. Die Anode der mittleren Diode D4 ist über ein erstes Verzögerungsglied P3 mit dem Ausgang der Hilfssignalquelle G verbunden. Die Anode der untersten Diode D5 ist über das erste Verzögerungsglied P3 und ein zweites Verzögerungsglied P4 mit dem Ausgang der Hilfssignalquelle G verbunden. Damit erreicht man auf der dritten Laufzeitleitung L3 eine Überlagerung des unverzögerten, des allein vom ersten Verzögerungsglied P3 verzögerten und des sowohl vom ersten Verzögerungsglied P3 als auch vom zweiten Verzögerungsglied P4 verzögerten Impulses zu einem insgesamt breiteren Impuls. Diese Impulsverbreiterung ist vorteilhaft, weil vorzugsweise sehr schmale Impulse auf die Laufzeitleitungen L1 und L2 gegeben werden, damit eine möglichst große Modulationsbreite erzielbar ist, die proportional zum Abstand zwischen zwei aufeinanderfolgenden Impulsen der Hilfssignalquelle ist. Bei einer bestimmten erforderlichen Modulationsbreite kann man durch schmale Impulse von der Hilfssignalquelle G den Abstand der nacheinander auf die Laufzeitleitungen gegebenen Impulse kleiner machen, damit man eine möglichst hohe Abtastfrequenz erreicht. d.h., Analogsignale mit hoher Frequenz in einen Digitalcode umsetzen kann.

Die Anzahl der Abgriffe A31, A32, ... der dritten Laufzeitleitung L3 stimmt mit der Anzahl der Meßpaare der Laufzeitleitungen L1 und L2 überein. Die einzelnen Abgriffspunkte A31, A32, ... der dritten Laufzeitleitung L3 bilden
zusammen mit den zugehörigen Meßpaaren der Laufzeitleitungen
L1 und L2 Meßtripel. Für jedes Meßtripel gilt, daß der Abstand des Abgriffspunktes der dritten Laufzeitleitung L3 vom
Leitungsanfang gleich dem arithmetischen Mittel der Abstände
der zugehörigen beiden Abgriffspunkte der beiden Laufzeitleitungen L1 und L2 von deren Leitungsanfängen ist. Für jedes
Schieberegister SR1, SR2, ... wird vom zugehörigen Abgriff A31,
A32, ... der dritten Laufzeitleitung L3 dadurch zu demjenigen
Zeitpunkt das zugehörige Schieberegister eingangsseitig geöffnet,
zu welchem bei entsprechender Phasenverschiebung durch den
Momentanwert des Analogsignals die beiden zueinander
gehörenden Impulse auf den beiden Laufzeitleitungen gleichzeitig an den Abgriffspunkten des zugehörigen Meßpaares auftreten.

Auf diese Weise wird eine Art Selbststeuerung der einzelnen
Schieberegister erreicht. Dies führt dazu, daß die Hilfssignal-Impulse in einem seitlichen Abstand auf die Laufzeitleitungen gegeben werden können, der kürzer ist als
die zum Durchlaufen der Laufzeitleitungen benötigte Laufzeit.

Der bei jeder Abfrage des Ausgangs des zugehörigen UND-
Gliedes U1, U2, ... in die erste Stufe des Schieberegisters eingespeicherte Logikwert wird dann bei den
folgenden Verschiebetaktimpulsen durch das Schieberegister geschoben. Diese Verschiebung geschieht für die
einzelnen Schieberegister SR1, SR2,... zeitlich versetzt.

Das in den Ausgangsstufen der Schieberegister SR1, SR2, ...
verfügbare Quantisierungsmuster kann dann zur weiteren Verarbeitung abgenommen werden, beispielsweise über einen
Pufferspeicher, in den die Quantisierungswerte der einzelnen Schieberegister-Ausgangsstufen zu den verschiedenen
Verschiebetaktzeiten eingespeichert und mittels Auslesetakten gleichzeitig ausgelesen werden.

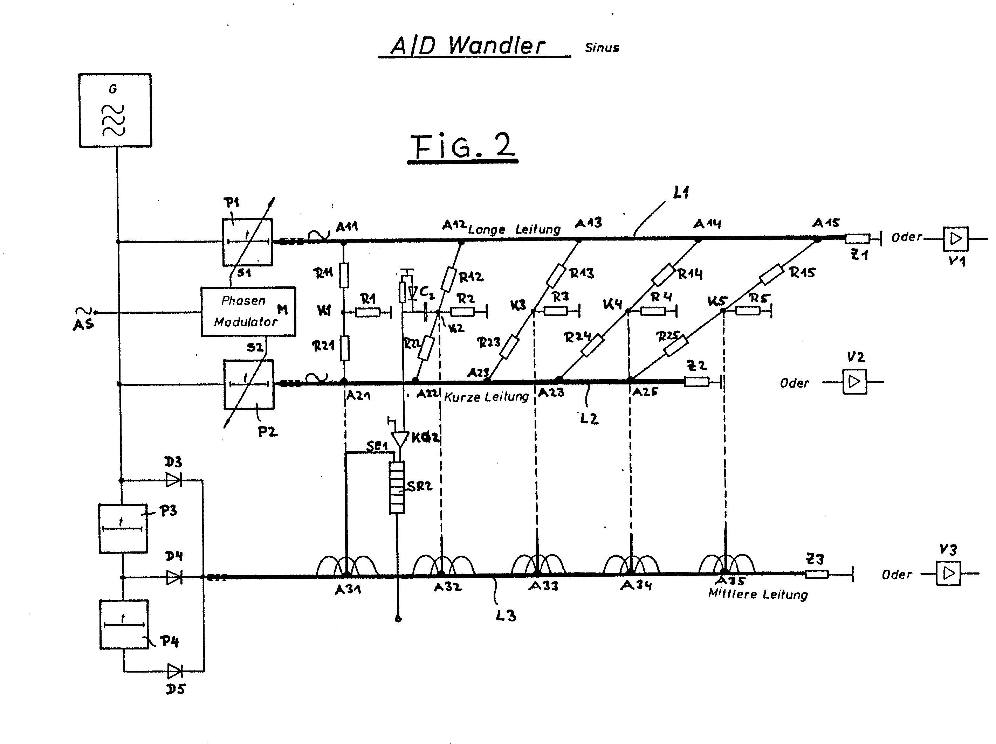

Fig. 2 zeigt eine Ausführungsform des erfindungsgemäßen
A/D-Wandlers, die sich für das Einspeisen eines Dauerschwingungssignals, beispielsweise Dauersinussignals,
in die Laufzeitleitungen eignet. Bei dieser Ausführungsform sind Komponenten, die Komponenten in der Ausführungsform nach Fig. 1 entsprechen, mit gleichen Bezugszeichen gekennzeichnet. Soweit der Schaltungsaufbau der
gleiche ist, ist auch der Funktionsablauf der gleiche
und braucht nicht nochmals erläutert zu werden. Die Ausführungsform gemäß Fig. 2 unterscheidet sich von der Ausführungsform gemäß Fig. 1 im wesentlichen dadurch, daß
die Vergleichseinrichtungen nicht durch UND-Glieder sondern durch summierende Widerstandsnetzwerke und daran
angeschlossene Komparatoren gebildet sind. Die Abgriffspunkte A11, A12, ... und A21, A22, ... eines jeden Meßpaares sind über eine Reihenschaltung aus zwei Widerständen R11, R12, ... und R21, R22, ... miteinander verbunden. Die an den beiden Abgriffspunkten auftretenden
Hilfssignalwerte treten an einem Verbindungspunkt K1, K2, ...
zwischen den beiden Widerständen R11, R12, ... und R21, R22,
... auf. Jeder Verbindungspunkt K1, K2, ... ist über einen
Widerstand R1, R2, ... mit Masse verbunden.

An jeden der Verbindungspunkte K1, K2, ... ist eine Vergleichseinrichtung in Form eines Komparators angeschlossen, der in Fig. 2 nur für das zweite Meßpaar mit den Abgriffspunkten A12 und A22 dargestellt und mit Ko2 bezeichnet ist. Ein Eingang des Komparators Ko2 ist mit Masse verbunden. Der andere Eingang des Komparators Ko2 ist über einen Kondensator C2 mit dem Verbindungspunkt K2 des zugehörigen Meßpaares verbunden.

Wenn das von der Hilfssignalquelle G kommende Sinussignal an beispielsweise den Abgriffspunkten A12 und A22 des zweiten Meßpaares mit einem Phasenunterschied von 180° ankommt, führt dies zu einer Auslöschung dieser beiden Signalwerte am Verbindungspunkt K2. Am Ausgang des Komparators Ko2 wird dieses Auslöschen durch einen bestimmten Logikwert, beispielsweise den Logikwert "0", angezeigt. Die Länge der beiden Laufzeitleitungen L1 und L2 muß so gewählt sein, daß bei der Frequenz des von der Hilfssignalquelle G kommenden Sinussignals spätestens im letzten Meßpaar eine Phasenverschiebung von 180° auftritt. Ist dies durch die Länge der Laufzeitleitungen nicht gewährleistet, muß man entweder die Frequenz der Hilfssignalquelle erhöhen oder einen Frequenzvervielfacher am Ausgang der Hilfssignalquelle G oder je einen Frequenzvervielfacher vor dem Eingang der beiden Laufzeitleitungen verwenden. Vorzugsweise sind diese Frequenzvervielfacher frequenzmäßig umschaltbar. Je höher man die Frequenz des Hilfssignal macht, umso kürzer können die Längen der Laufzeitleitungen sein, nach denen die erforderliche Phasenverschiebung von 180° zwischen den Laufzeitleitungen erreicht ist.

Bei einer Ausführungsform mit einer dritten Laufzeitleitung L3 wird für den Fall, daß die Frequenzvervielfacher zwischen die Phasenkomparatoren P1 und P2 und
die Laufzeitleitungen L1 und L2 geschaltet sind, auch
dem Leitungsanfang der dritten Laufzeitleitung L3 ein
Frequenzvervielfacher vorgeschaltet.

Beispielsweise benutzt man eine Frequenzvervielfachung
von 1 zu 3. Der Betrag der Phasenverschiebung zwischen
den Signalen auf den beiden Laufzeitleitungen L1 und L2
ändert sich mit dem Faktor der Frequenzvervielfachung.
Dadurch kann man eine Erhöhung der Auflösungsempfindlichkeit um den Faktor der Frequenzvervielfachung erreichen.
Macht man den bzw. die Frequenzvervielfacher frequenzmäßig umschaltbar, kann man bei feststehender Frequenz
des Hilfssignals der Hilfssignalquelle G eine Auflösungsempfindlichkeitsumschaltung vornehmen, um sich je nach
Bedarf die geeignete Auflösungsempfindlichkeit bzw.
Wandlungsgenauigkeit bei der A/D-Umwandlung auszuwählen.

Auch bei dieser Ausführungsform kann man an die Ausgänge der Komparatoren je ein Schieberegister anschliessen und den Verschiebetakt für jedes dieser Schieberegister durch Verschiebetaktimpulse steuern, die von den
einzelnen Abgriffen A31, A32, ... der dritten Laufzeitleitung L3 gewonnen werden.

Bis zu einem maximalen Phasenunterschied zwischen den
beiden Hilfssignalen auf den beiden Laufzeitleitungen
L1 und L2 von 180° kann als Meßsignal ein Dauersinussignal verwendet und die Ausführungsform gemäß Fig. 2
benutzt werden. Darüberhinaus müssen Impulse, beispielsweise in Form von Rechteckimpulsen, Dreiecksimpulsen, Einzelsinusimpulsen u.s.w., verwendet werden. Mit langen Laufzeitleitungen kann ein größerer Phasenunterschied zwischen den beiden Hilfssignalen auf den beiden Laufzeitleitungen L1 und L2 erreicht werden, und man kann eine größere Anzahl Meßpaare längs der Laufzeitleitungen L1 und L2 unterbringen, so daß eine höhere Auflösung und damit höhere Genauigkeit bei der Analog/Digital-Umsetzung möglich wird. Das hat allerdings zur Folge, daß die Hilfsimpulse mit größeren Zeitabständen auf die Laufzeitleitungen L1 und L2 geschickt werden müssen, so daß die Abtastfrequenz der Abtastung des Analogsignals niedriger wird. Daraus folgt wiederum, daß nur Analogsignale mit geringerer Frequenz umgesetzt werden können.

Zur Umsetzung von Analogsignalen besonders hoher Frequenzen benutzt man vorteilhafterweise im Fall der Ausführungsform nach Fig. 1 dicht aufeinanderfolgende Hilfssignal-Impulse und im Fall der Ausführungsform nach Fig. 2 eine entsprechend höhere Frequenz des Dauersinussignals, und zwar in Kombination mit der dritten Laufzeitleitung und den Schieberegistern, deren Verschiebungstakte durch die Impulse bzw. gleichgerichteten Sinushalbwellen, die an den einzelnen Abgriffspunkten der dritten Laufzeitleitung auftreten, gesteuert werden.

KADOR · KLUNKER · SCHMITT-NILSON · HIRSCH

PATENTANWÄLTE
EUROPEAN PATENT ATTORNEYS

DR. UTZ KADOR DIPL.-CHEM
DR. FRIEDER KLUNKER DIPL.-ING
DR GERT SCHMITT-NILSON DIPL.-ING
PETER HIRSCH DIPL.-ING

D-8000 MÜNCHEN 5
CORNELIUSSTR 15

TELEPHONE (089-2015250
TELECOPIER (089 2014454
TELEX 5 23517 kkpa
CABLE helpa

KADOR KLUNKER SCHMITT-NILSON HIRSCH CORNELIUSSTRASSE 15 8000 MÜNCHEN 5

Hans WERBA
Theresienstraße 11
8390 Passau

u.Z.: K 21 192 K6-sw

Analog/Digital-Wandler

## - 1 -

### Patentansprüche

1. Analog/Digital-Wandler,
mit einem Paar Laufzeitleitungen, die eingangsseitig mit
Hilfssignalen gleicher Signalform beaufschlagt werden, wobei diese Signale durch Impulse gebildet werden,
mit einer steuerbaren Phasenveränderungseinrichtung, mittels
der unter Steuerung durch das umzusetzende Analogsignal ein
Phasenunterschied zwischen den Hilfssignalen auf den beiden
Laufzeitleitungen entsprechend der Analogsignaländerung modulierbar ist,
und mit einer Vergleichsvorrichtung, mittels welcher an
vorbestimmten Abgriffspunkten an den beiden Laufzeitleitungen die Hilfssignale auf den beiden Laufzeitleitungen
auf Betragsgleichheit oder Betragungleichheit verglichen
werden,
dadurch gekennzeichnet ,

daß jede Laufzeitleitung (L1, L2) mehrere in Längsrichtung
versetzte Abgriffe (A11, A12,..., A21, A22,...) aufweist,
daß der erste (A11), der zweite (A12), der dritte (A13)
u.s.w Abgriff einer Laufzeitleitung (L1) mit dem ersten (A21)
bzw. zweiten (A22) bzw. dritten (A23) u.s.w. Abgriff der anderen Laufzeitleitung (L2) je ein Meßpaar bilden, daß die
Gruppenlaufzeit von den Leitungsanfängen bis zu den beiden
Abgriffen eines jeden Meßpaares, mit Ausnahme eines Meßpaares,
unterschiedlich ist, daß der Unterschied zwischen den Gruppenlaufzeiten von den Leitungsanfängen bis zu den Abgriffen eines
Meßpaares für die verschiedenen Meßpaare ebenfalls unterschiedlich ist, daß jedem Meßpaar eine Vergleichsvorrichtung
(z. B. R21, R22, R2, C2, D2, R6, Ko2; z.B. U2) zugeordnet ist
und daß die Vergleichsergebnisse aller Vergleichsvorrichtungen
das dem umzusetzenden Analogsignal (AS) entsprechende Quantisierungsmuster bilden.


2.    Analog/Digital-Wandler nach Anspruch 1,
dadurch g e k e n n z e i c h n e t,
daß die steuerbare Phasenveränderungseinrichtung durch
einen steuerbaren Phasenschieber (P1 oder P2) gebildet ist,
der vor den Leitungsanfang einer der beiden Laufzeitleitungen (L1 oder L2) geschaltet ist,
und daß das umzusetzende Analogsignal (AS) einem Steuereingang (S1 bzw. S2) des Phasenschiebers (P1 oder P2)
als Phasensteuersignal zuführbar ist.


3.    Analog/Digital-Wandler nach Anspruch 1,
dadurch g e k e n n z e i c h n e t,
daß die steuerbare Phasenveränderungseinrichtung durch
zwei steuerbare Phasenschieber (P1 und P2) gebildet ist,
die je vor den Leitungsanfang einer der beiden Laufzeitleitungen (L1, L2) geschaltet sind, und daß das umzusetzende Analogsignal (AS) dem Steuereingang (S1, S2) eines jeden Phasenschiebers (P1, P2)
als Phasensteuersignal zuführbar ist, derart, daß die
Phasenverschiebung der beiden Phasenschieber (P1, P2)
vom Analogsignal (AS) im Gegensinn verändert wird.


4.    Analog/Digital-Wandler nach Anspruch 2 oder 3,
dadurch g e k e n n z e i c h n e t ,
daß jeder Phasenschieber (P1, P2) einen Phasenverschiebungsbereich von 0° bis 180° aufweist und bei einem
Analogsignal Null auf einen Phasenverschiebungswinkel von
90° eingestellt ist.


5.    Analog/Digital-Wandler nach einem oder mehreren
der Ansprüche 1 bis 4,
dadurch g e k e n n z e i c h n e t ,
daß die einem jeden Meßpaar zugeordnete Vergleichseinrichtung eine Reihenschaltung aus zwei Widerständen
(z. B. R12, R22) aufweist, die zwischen die zu diesem
Meßpaar gehörenden Abgriffspunkte (z. B. A12, A22)
geschaltet sind und mit ihrem Verbindungspunkt (z. B.
K2) an einen Eingang eines Komparators (Ko2) angeschlossen
sind, dessen anderer Eingang mit einem Bezugspotential
beaufschlagbar ist, wobei die Ausgangszustände der einzelnen Komparatoren (z. B. Ko2) das Quantisierungsmuster
darstellen.


6.    Analog/Digital-Wandler nach einem oder mehreren
der Ansprüche 1 bis 4,
dadurch g e k e n n z e i c h n e t ,
daß die einem jeden Meßpaar zugeordnete Vergleichseinrichtung eine UND- oder NAND-Schaltung (z. B. U1)
aufweist, mit zwei Eingängen, die mit den Abgriffspunkten (z. B. A11, A21) des Meßpaares verbunden sind.

7.   Analog/Digital-Wandler nach Anspruch 5 oder 6,
dadurch g e k e n n z e i c h n e t,
daß der Ausgang jedes Komparators (z. B. Ko2) bzw.
jeder UND- bzw. NAND-Schaltung (z. B. U2) mit der
Eingangsstufe eines n-stufigen Schieberegisters
(z. B. SR2) verbunden ist,
daß eine dritte Laufzeitleitung (L3) vorgesehen ist,
die ebenfalls mit den Hilfssignal-Impulsen gespeist
wird und gleichviele Abgriffspunkte (A31, A32, ...)
wie jede der anderen beiden Laufzeitleitungen (L1, L2)
aufweist, wobei die Abgriffspunkte (z. B. A32) der
dritten Leitung (L3) je mit einem zugehörigen Meßpaar
(z. B. A12, A22) der beiden anderen Laufzeitleitungen
(L1, L2) ein Meßtripel (z. B. A12, A22, A32) bilden,
wobei bei jedem Meßtripel der Abstand des Abgriffspunktes
an der dritten Laufzeitleitung (L3) vom Leitungsanfang
dieser dritten Laufzeitleitung (L3) dem arithmetischen
Mittel der Abstände der Abgriffspunkte des zugehörigen
Meßpaares der beiden anderen Laufzeitleitungen (L1, L2)
gleich ist,
und daß jeder Abgriffspunkt (z. B. A32) der dritten Laufzeitleitung (L3) mit dem Schiebetakteingang  (z. B. SE2)
desjenigen Schieberegisters (z. B. SR2) verbunden ist,
welches dem zugehörigen Meßpaar zugeordnet ist, wobei
den letzten Stufen aller Schieberegister (SR1, SR2, ...)
das Quantisierungsmuster entnehmbar ist.

8.   Analog/Digital-Wandler nach Anspruch 7,
dadurch g e k e n n z e i c h n e t , daß der dritten
Laufzeitleitung (L3) eine Impulsverbreiterungsschaltung
(P3, P4, D3, D4, D5) vorgeschaltet ist.

9. Analog/Digital-Wandler nach Anspruch 8,
dadurch g e k e n n z e i c h n e t,
daß die Impulsverbreiterungsschaltung eine Parallelschaltung aus drei Leitungszweigen aufweist, an deren
Ausgang der Leitungsanfang der dritten Laufzeitleitung
(L3) angeschlossen ist, und daß der Eingang einer der
drei Leitungszweige direkt mit der Hilfssignalquelle (G),
der mittlere Leitungszweig über ein erstes Verzögerungsglied (P3) mit der Hilfssignalquelle (G) und der dritte
Leitungszweig über eine Serienschaltung aus dem ersten
Verzögerungsglied (P3) und einem zweiten Verzögerungsglied (P4) mit der Hilfssignalquelle (G) verbunden ist.

10. Analog/Digital-Wandler nach Anspruch 9,
dadurch g e k e n n z e i c h n e t,
daß in die Leitungszweige je eine Diode (D3, D4, D5)
mit gleicher Polarität geschaltet ist.

11. Analog/Digital-Wandler nach einem oder mehreren
der Ansprüche 1 bis 10,
dadurch g e k e n n z e i c h n e t,
daß in jede der Laufzeitleitungen (L1, L2, gegebenenfalls
L3) mindestens ein Leitungsverstärker (V1, V2, gegebenenfalls V3) eingefügt ist.

12. Analog/Digital-Wandler nach einem oder mehreren
der Ansprüche 1 bis 11,
dadurch g e k e n n z e i c h n e t,
daß die Laufzeitleitungen (L1, L2, gegebenenfalls L3)
am Leitungsende mit einer Impedanz (Z1, Z2, gegebenenfalls Z3) gleich dem Wellenwiderstand der jeweiligen
Laufzeitleitung (L1, L2, gegebenenfalls L3) abgeschlossen
sind.

13. Analog/Digital-Wandler nach einem oder mehreren der Ansprüche 5 und 7 bis 12, dadurch g e k e n n z e i c h n e t, daß in die Laufzeitleitungen (L1, L2, gegebenfalls L3) als Hilfssignal eine kontinuierliche Sinuswelle eingespeist wird.

14. Analog/Digital-Wandler nach Anspruch 13, dadurch g e k e n n z e i c h n e t, daß zwischen den bzw. die Phasenschieber (P1, P2, gegebenenfalls P3, P4) und den Leitungsanfang der zugehörigen Laufzeitleitung (L1, L2, gegebenenfalls L3) ein Frequenzvervielfacher geschaltet ist.

15. Verwendung des Analog/Digital-Wandlers nach einem oder mehreren der vorausgehenden Ansprüche als Stufenschalter, dadurch gekennzeichnet, daß der Phasenveränderungseinrichtung (M, P1, P2) als Analogsignal ein Sägezahnsignal zugeführt wird und daß die Ausgänge der Vergleichsvorrichtungen die einzelnen Schalterausgänge bilden, an denen der Reihe nach mit zeitlicher Versetzung Schaltsteuersignale auftreten, wobei der zeitliche Abstand ($\Delta t$) zwischen den Schaltsteuersignalen an den einzelnen Schalterausgängen durch die Anstiegssteigung des Sägezahnsignals steuerbar ist.

# A/D Wandler

# FiG. 1

A/D Wandler    Sinus

FIG. 2

Europäisches
Patentamt

# EUROPÄISCHER RECHERCHENBERICHT

0154661

EP 84 10 2876

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | ELEKTRONIK, Band 31, Nr. 19, 24. September 1982, Seite 28, München, DE; "A/D-Umsetzer für 1 GHz" | | H 03 M 1/64 |
| | --- | | |
| A | FR-A-1 357 567 (THOMSON-HOUSTON)(24.02.1964) * Seite 1, Spalte 2, Zeilen 15-33; Figur 1 * | 1 | |
| | ----- | | |

| RECHERCHIERTE SACHGEBIETE (Int. Cl.4) |
|---|
| H 03 M |

Der vorliegende Recherchenbericht wurde für alle Patentansprüche erstellt.

| Recherchenort | Abschlußdatum der Recherche | Prüfer |
|---|---|---|
| DEN HAAG | 14-11-1984 | BEINDORFF W.H. |